# EUROPEAN PATENT SPECIFICATION

(11) **EP 4 664 117 B1**
(45) Date of publication and mention of the grant of the patent: **25.11.2026**
(21) Application number: 24425030.4
(22) Date of filing: 11.06.2024
(51) Int. Cl.: G01R 1/067, G01R 1/073

(54) **CONTACT PROBE WITH CUSTOMIZABLE GEOMETRY AND RELATIVE PROBE HEAD**
KONTAKTSONDE MIT ANPASSBARER GEOMETRIE UND ENTSPRECHENDER SONDENKOPF
SONDE DE CONTACT À GÉOMÉTRIE PERSONNALISABLE ET TÊTE DE SONDE RELATIVE

(43) Date of publication of application: 17.12.2025
(73) Proprietor: Microtest S.p.A., 56010 Vicopisano (PI) (IT)
(72) Inventor: AMELIO, Giuseppe, 55100 San Pietro (LU) (IT)
(74) Representative: Botti & Ferrari S.p.A.

(56) References cited:
- WO-A1-2017/119676
- US-A1- 2002 153 913
- US-A1- 2007 007 974
- US-A1- 2019 353 684
- US-A1- 2021 132 112
- US-A1- 2022 334 145

## Description

### Field of application

The present invention refers to a contact probe having an improved structure for a probe card and a related testing head for performing tests on an electronic component under test.

More particularly, the invention preferably, but not limitedly, relates to a testing head of the type intended to put a plurality of terminations or pads of components on wafers in contact with corresponding channels of a testing equipment to automatically perform some tests on the wafer components. This equipment is used in the production step of integrated electronic circuits to search for and discard any on-wafer-defective components.

### Prior art

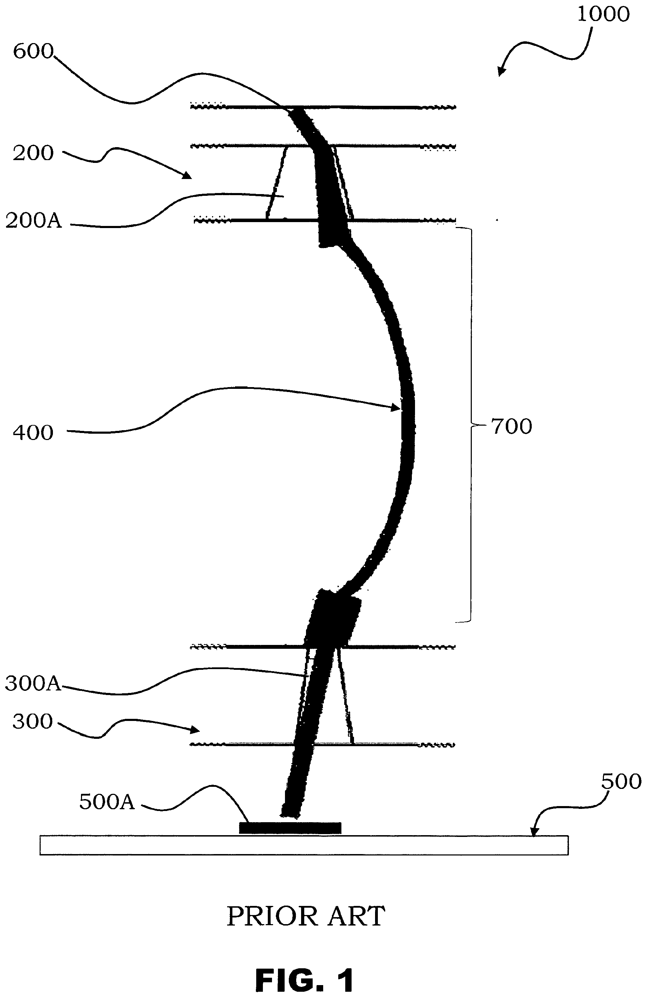

As shown by way of example in Figure 1 relating to the prior art, a testing head for a probe card of the above type usually comprises a pair of guide plates arranged parallel to each other in a prefixed spaced apart relation and provided with a plurality of guide and housing holes for probes or needles representing contact elements for the terminations of integrated circuits.

These contact probes of the testing head are made up of wires of special alloys which have peculiar electrical and mechanical properties, and which pass through the holes of the plates emerging from one of the two plates with an end or contact head.

The probes are mounted and held between the two plates in a position that is substantially perpendicular to the plates themselves so that, in the jargon of this specific technical field, they are defined "vertical probes". This specific substantially vertical configuration allows incorporating a relatively high number of probes per unit area, so as to be able to perform tests even on integral circuits characterized by extremely low pitches, in the order of 300-400 µm for the latest generation integrated circuits.

More particularly, the holes of the respective plates through which a certain probe passes are generally slightly offset so that each probe is axially mobile through the respective housing holes, but with some friction which, along with the inherent flexibility of the probes themselves, confers a certain overall ability to withstand compression to the testing head assembly, as if it were slightly cushioned.

Examples of this type of testing heads are described in European patent no. EP 1 197 756 B1 and in international patent no. WO 2021/2500598 in the name of the same Applicant. A further example of testing heads is disclosed in document WO 2017/119676 A1.

In use, the testing head of the probe card is subject to pressure to ensure good contact between the probe heads and the terminations of the integrated circuits being tested and this pressure produces a bending of the probes inside the separation space between the two parallel plates.

Their flexibility and/or the degree of axial sliding freedom of the probes through the respective guide holes of the plates is not only useful to confer the above bending ability to the entire testing head, but it is also useful to remove the probes in order to replace them in case of breakage.

Although the testing heads and related contact probes described above have increasingly better features, they are far from optimal, in particular because different configurations of the tested semiconductor cards can determine different performances of the carried-out tests.

The technical problem underlying the present invention is to conceive a new structure of contact probe and related testing head for probe cards having structural and functional features so as to ensure the best test performances by adapting in the best way to the specific product under test.

Another object of the invention is to provide a testing head which is highly efficient.

In particular, an object of the invention is to optimize the contact pressure on the die (whether it is equipped with a pad or a bump) and on the integrated circuit of the probe card.

An object of the present invention is still to allow optimal control of the geometric configuration deformed under load, therefore to allow reduced pitches on both the X and Y directions.

Finally, an object of the invention is to provide a solution that is simple to maintain.

### Summary of the invention

The solution idea underlying the present invention is to provide specific and optimized technical solutions for each test to be carried out through geometric modifications of the probe.

Based on this solution idea, the technical problem is solved by a contact probe as defined by claim 1. The contact probe comprises a first end having a first contact tip adapted to contact a pad or a bump of a component on wafers, a second end having a second contact tip adapted to contact a probe card, and a central body which extends between the first end and the second end. In said contact probe, a cross-sectional area at the central body is smaller than a cross-sectional area at the first end and a cross-sectional area at the second end, the central body has at least one portion with a rectilinear configuration, which develops along a longitudinal axis, and at least one portion with a curvilinear configuration, which moves away from said longitudinal axis.

An extension, measured along the aforementioned longitudinal axis, of a first longitudinal section D comprising the second end and the portion with a rectilinear configuration and an extension, again measured along the aforementioned longitudinal axis, of a second section L comprising the second end and the entire central body provide a reciprocal D/L ratio between 0.4 and 0.65.

Advantageously, the present solution allows to maintain the necessary substantially rectilinear configuration of the contact probe, to provide a correct elastic resistance and to always allow a simple insertion of the contact probe into suitable guides of a testing head.

Preferably, the central body provides for a width or a transversal dimension T, which is orthogonal to a longitudinal extension H of the central body, and a thickness S of the contact probe, measured orthogonally to the width, which are different from each other.

In particular, the width T of said central body is between 1.2*S and 1.95*S, wherein S is the thickness of the central body.

Advantageously, the present solution allows to have geometric relationships optimized with respect to the needs of the product under test.

More preferably, the longitudinal extension H of the central body comprised between the first end and the second end is between 100*S and 150*S, wherein S is a thickness of the contact probe in the section of the central body.

Advantageously, the present elongated and threadlike shape further optimizes the ease of insertion and the elastic capacity of the contact probe.

Preferably, said central body has an almost constant cross section.

Advantageously, managing the sizing of the probe body allows to control the positioning error inside guide holes and to optimize the friction forces that oppose the sliding of the contact probe under load.

Preferably, the first end comprises a first portion with a larger section and a first portion with a smaller section, the first contact tip being in the first portion with a smaller section.

Advantageously, the dimensional control of the ends of the contact probe allows optimizing the contact pressure, and therefore the contact resistance, of the contact probe, and the probe sign.

More preferably, a taper and/or a stepped portion are provided between the first portion with a larger section and the first portion with a smaller section. More preferably, the taper defines a decrease in the width of the first portion with a larger section, while the subsequent stepped portion defines a sharp decrease in the thickness.

Advantageously, the present shape is simplified in terms of production.

Preferably, the portion with a smaller section has a cross section with a thickness and width which are equal to each other, and in particular substantially equal to the thickness of at least one cross section of said central body.

Preferably, the second end comprises a second portion with a larger section and a second portion with a smaller section, the second contact tip being in the second portion with a smaller section.

Again, advantageously, the dimensional control of the ends of the contact probe allows the contact pressure to be optimized.

More preferably, a chamfer portion is provided between the second portion with a larger section and the second portion with a smaller section.

Still more preferably, the contact probe according to the invention further comprises an abutment element which is transverse to a longitudinal extension of the contact probe laterally projecting with respect to said second portion with a larger section.

Advantageously, on the one hand, this abutment element allows to control the stroke of the contact probe to be inserted into the testing head, thus defining a stop abutment which abuts against the upper surface of an upper guide plate; on the other hand it acts as a visual reference for recognizing the orientation of the contact probe itself during assembly.

Advantageously, the present shape further allows to optimize the management of the pressure while using the contact probe.

Preferably, a first tapering portion is provided between the first end and the central body and a second tapering portion is provided between the second end and the central body.

The base of said second tapering portion can in particular define a shoulder for resting on a lower guide plate.

Advantageously, the present shape further facilitates the insertion of the contact probe and is practical in terms of production.

According to a different aspect, the present invention refers to a testing head for a probe card comprising an upper guide plate and a lower guide plate, respectively comprising a first guide hole and a second guide hole and comprising at least one contact probe as described above.

The probe according to the invention can advantageously be inserted with a simplified vertical assembly, thus requiring the control of a single linear degree of freedom of the body. Actually, a coordinated movement with combined linear and rotary degrees of freedom is not necessary, since the probe is inserted from above and is able to slide until the respective abutment elements abut on the lower and upper guide plates.

Advantageously, the present invention allows to provide testing heads optimized for different types of tests on different semiconductor boards.

Further features and advantages will become apparent from the detailed description given below of a preferred, but not exclusive, embodiment of the contact probe and of the testing head according to the present invention, with reference to the attached figures given by way of example and without limitation.

### Brief description of the drawings

In said drawings:
- Figure 1 shows a schematic view of a testing head made according to the prior art;
- Figure 2 shows a schematic view of an embodiment of a testing head according to the present disclosure;
- Figure 3 shows a schematic view of the embodiment of a contact probe according to the present disclosure;
- Figure 3A shows a cross section taken according to the plane A-A of Figure 3;
- Figure 3B shows a cross section taken according to the B-B plane of figure 3;
- Figure 4 shows a schematic view of a detail of the contact probe in the testing head of Figure 2;
- Figure 5 shows a schematic perspective view of a first end of the contact probe of Figure 2;
- Figure 6 shows a schematic perspective view of a second end of the contact probe of Figure 2.

### Detailed description

With reference to the figures of the attached drawings, reference number 100 globally and schematically show a testing head comprising at least one contact probe 1, preferably vertical probes, for a so-called probe card, made according to the present disclosure.

It should be noted that the figures show schematic views and are not drawn to scale, but so as to emphasize the most important aspects and features of the present disclosure. The shapes of the elements and of the component parts of the testing head are also not binding.

In the technical jargon the testing head is also called probe head and is the termination structure of a probe card associated with a testing equipment; the probe head is provided to house the contact probes with the devices under test, which are usually integrated electronic circuits still arranged on wafers or other types of printed circuits.

Actually the probe card is an electromechanical interface between the testing equipment and a semi-conductor wafer, but in the drawings the entire equipment has not been shown since it is conventional and well-known in this technical field.

In the drawings (Fig. 1), a testing head 1000 of the known type is schematically shown, which comprises support plates 200, 300 and at least one probe 400 held in position by the plates, among the numerous probes that could be housed in parallel in the testing head.

The plate 200 is to be intended as a plate-shaped support or upper guide or "upper die", whereas the plate 300 is to be intended as a plate-shaped support or lower guide or "lower die". The plates 200, 300 are usually made of ceramic material and have a plurality of upper 200A and lower 300A guide holes through which the above at least one contact probe 400 slides.

The definitions "upper" and "lower" relate to the main method of use of these testing heads, which are usually horizontally extended above a wafer under test with the plate 200 arranged above the plate 300, but this must not represent any limitation to the rights of the Applicant.

The upper plate 200 and the lower plate 300 are mounted parallel to each other and suitably spaced apart by a space 700 which is provided to allow the movement and/or the elastic deformation of the contact probes 400.

The contact probe 400 ends with a contact tip end 400A intended to abut onto a termination or contact pad 500A of a device under test 500 (Device Under Test = DUT), for instance a semiconductor wafer.

The probes 400 are in turn constrained to the upper plate 200 and are referred to as blocked-probe testing heads but, most commonly, the probes 4 are free to slide through the holes 200A and 300A, possibly with friction, to allow them to move between the plates. In some prior art solutions the probes are interfaced at the top to a so-called "board" via a contact board called "space transformer" or "interposer", which allows the coupling with the probe card.

The upper portion 600 of the probe is associated with the interposer.

The deformation of the probes within the space 700 and the sliding retainment with friction of the probes by the walls of the guide holes allows keeping the testing head cushioned during its use.

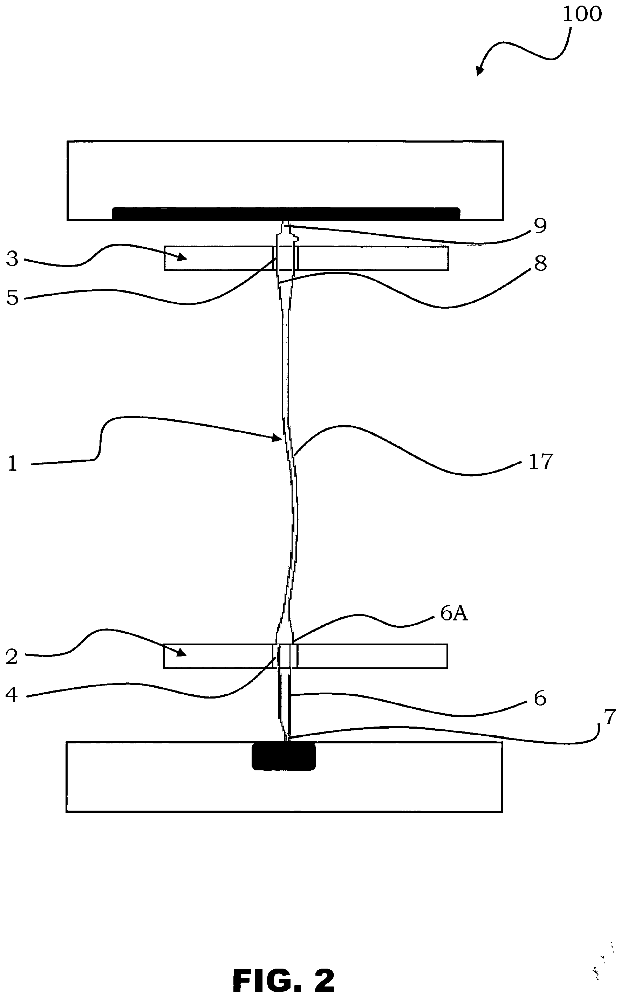

Figure 2 shows a first exemplary embodiment of the present disclosure, wherein the testing head 100 comprises at least one plate-shaped support 2 or upper probe guide and at least one plate-shaped support 3 or lower probe guide. These supports could be hereinafter simply referred to as guide plates.

Only by way of example it is pointed out that the thickness of these plate-shaped supports may vary from 2000 µm to 5000 µm; anyway, thicknesses of said supports beyond these limits are not excluded.

The guide plates 2, 3 are planar and parallel to each other and respectively comprise at least one first guide hole 4 and at least one second guide hole 5 within which the contact probes 1 are slidingly housed. During the use of the testing head the plates 2, 3 are also parallel to a device under test.

Substantially the holes 4, 5 of the plates are equal in number and position so that the at least one probe 1, in general the plurality of probes 1, may be slidingly housed perpendicularly extending with respect to the lying plane of the guide plates 2, 3. For this reason, they are usually referred to as testing heads with vertical probes, actually referring to the methods of use of these testing heads.

The contact probe 1, according to the present invention, is also preferably intended for probe cards for testing components on wafers. The probes are assembled, manually or automatically, inside the support and guide structure, namely the probe head, which is therefore the electrical and mechanical interface between probe card and wafer.

The contact probe 1 according to the invention can be customized in order to be adopted on components with pads or on components with bumps.

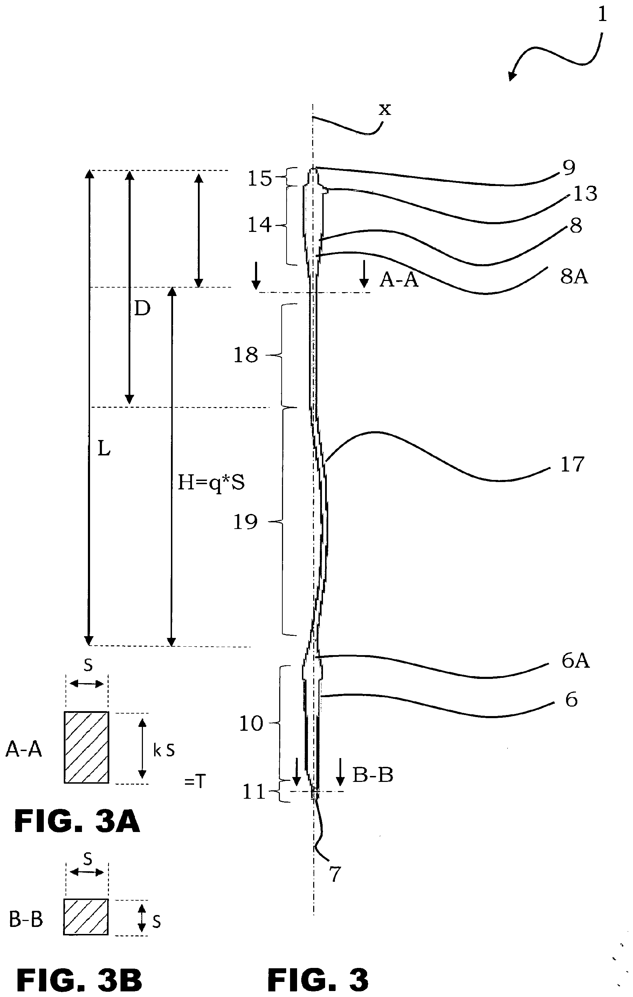

As also specifically visible in Figure 3, the contact probe 1 comprises a first end 6 having a first contact tip 7 which is adapted to contact a pad or a bump of the semiconductor board (or "die").

A second end 8 having a second contact tip 9 which is adapted to contact a probe card (or "probe head") is provided opposite the first end 6.

The first end 6 comprises a first portion with a larger section 10 and a first portion with a smaller section 11, the section decreasing towards the first contact tip 7 which is therefore the end of the first portion with a smaller section 11 and which contacts the "die".

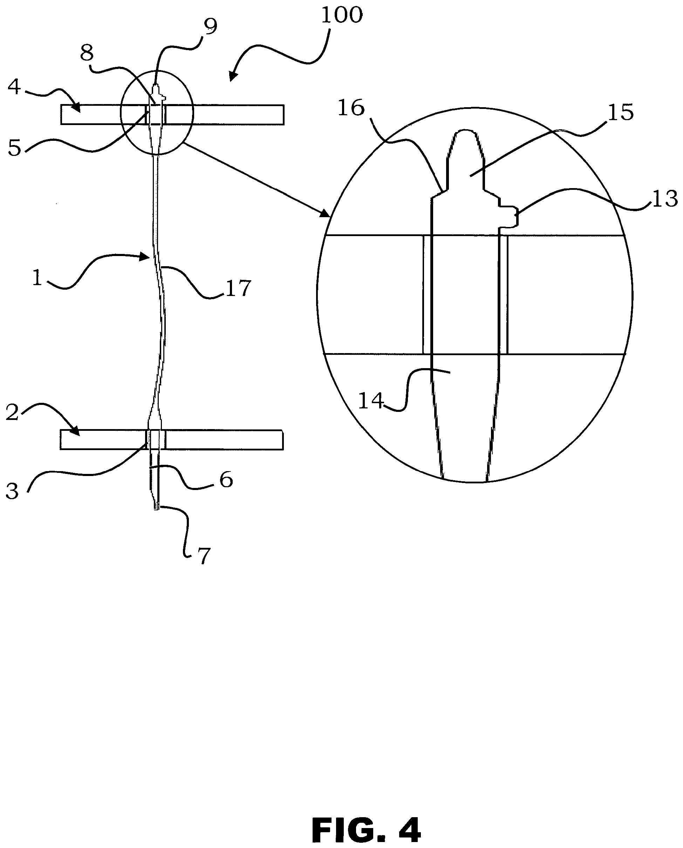

As can be seen more specifically in the detail of Figure 4, a taper followed by a stepped portion 12 is provided between the first portion with a larger section 10 and the first portion with a smaller section 11.

The second end 8 also comprises a second portion with a larger section 14 and a second portion with a smaller section 15, the section decreasing towards the second contact tip 9 which is therefore the end of the second portion with a smaller section 15 and which contacts the "probe head".

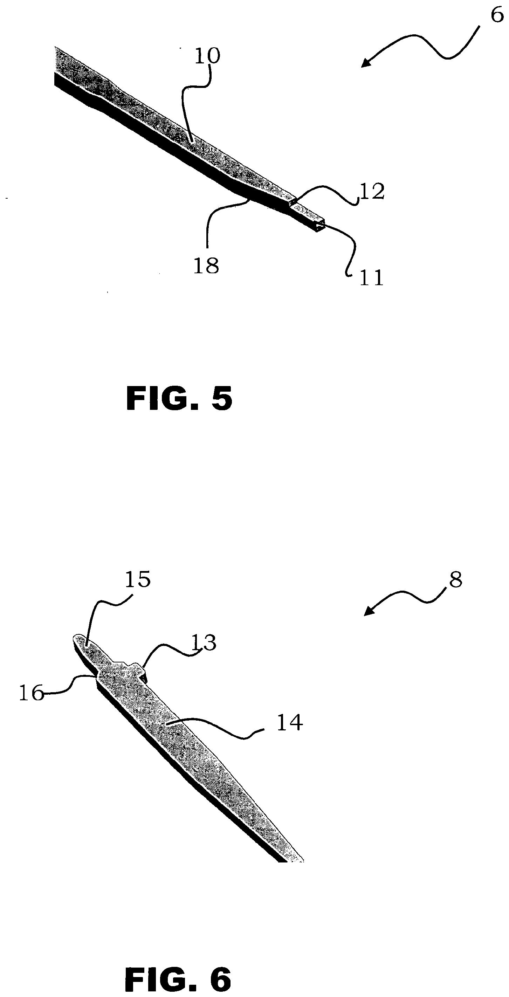

As visible in Figure 6, the shape of the second end 8 is however different from the first end 6, with a chamfer portion 16 between the second portion with a larger section 14 and the second portion with a smaller section 15.

However, nothing prevents from providing different shapes, even less practical ones in terms of production, such variants always being included within the scope of the attached claims.

Furthermore, as can be seen in the detail of Figure 4, near the chamfer portion 16, an abutment element 13, which is transversal to the longitudinal development of the contact probe 1, is provided.

This specific geometry clearly prevents the contact probe 1 from overtraveling with respect to the guide hole 5, but also serves as a visual reference for recognizing the orientation during assembly.

The geometric relationships between the various sub-parts constituting the contact probe 1 are so as to optimize the contact pressure on the "die" (both if pads and bumps are provided) and on the "probe card", and also allow the control of the geometric configuration deformed under load, thus allowing to have reduced pitches on both the longitudinal and transversal directions.

The geometric relationships are optimized based on the needs of the product under test.

Furthermore, both the first end 6 and the second end 8 of the contact probe 1 can have a controlled size so as to optimize the contact pressure, and therefore the contact resistance, and the probe sign.

The latter can also be made very small, meeting the needs of miniaturization of the pads on wafers.

In particular, as previously seen, both the main dimensions, thickness and width, of the section of one of the ends 6, 8 of the probe can be controlled. These dimensions can be defined independently from the same dimensions of the section of the remaining part of contact probe 1.

This additional degree of freedom can be achieved, for example, by a multi-step galvanic growth process or other methods.

A central body 17 substantially longitudinally extends between the first end 6 and the second end 8.

A first tapering portion 6A is preferably provided between the first end 6 and the central body 17 and a second tapering portion 8A is provided between the second end 8 and the central body 17, which allows the introduced portions of the guide holes to be enlarged so as to make their section proportional to the holes themselves, thereby obtaining greater precision and ease of positioning.

A cross-sectional area at the central body 17 is smaller than a cross-sectional area at the first end 6 and than a cross-sectional area at the second end 8.

The central body 17 generally provides at least one portion with a rectilinear configuration 18 and at least one portion with a curvilinear configuration 19.

As visible in Figure 3, according to the present invention, an extension of a first longitudinal section D comprising the second end 8 and the portion with a rectilinear configuration 18 and an extension of a second section L comprising again the second end 8 and the entire central body 17 provide a reciprocal D/L ratio between 0.4 and 0.65. In the present exemplary and non-limiting embodiment, the D/L ratio is equal to 0.4.

Furthermore, in the present exemplifying and non-limiting embodiment, again as visible in Figure 3, the central body 17 has a transversal dimension T, which is orthogonal to a longitudinal extension H of the central body 17 and to a thickness S of the contact probe 1 equal to k *S, wherein S is precisely the thickness of the contact probe 1 and the parameter k is a variable parameter between 1.2 and 1.95.

Furthermore, again in the exemplary and non-limiting embodiment, the extension H of the central body 17 comprised between the first end 6 and the second end 8 is equal to q*S, wherein S is always the thickness of the contact probe 1 and the parameter q is a variable parameter between 100 and 150.

The geometry of the central body 17 allows a simplified vertical assembly which requires the control of a single degree of freedom, specifically the linear displacement, of the central body 17, without the need for a coordinated movement with combined linear and rotary degrees of freedom.

Furthermore, the dimensions of the central body 17 are adapted to allow the control of the positioning error inside the guide holes 4, 5 and the optimization of the friction forces that oppose the sliding of the contact probe 1 under load.

Furthermore, the embodiments according to the present invention, even by varying the aforementioned parameters between the indicated extremes, allow maintaining a correct elastic property of the contact probe in the operational phase.

It should be noted that the contact probe 1 according to the present invention allows to overcome the drawbacks of the known solutions.

Advantageously, the contact probe 1 and the related testing head 100 for probe cards according to the invention guarantee optimal performances.

Furthermore, advantageously, the contact probe 1 according to the invention is highly efficient in a plurality of different test equipment and devices under test.

Further advantageously, the contact probe 1 according to the invention is particularly robust and long-lasting, thus reducing the time between maintenance operations.

Furthermore, advantageously according to the present invention, it is possible to optimize the mass production of customized contact probes 1 through targeted modifications.

A person skilled in the art will understand that the disclosed embodiment can be subject to further modifications and variations, according to specific and contingent needs, all included within the scope of protection of the invention, as defined by the following claims.

For example, it is possible to provide different dimensions and shapes of the mentioned components, all falling within the scope of said claims.

## Claims

1. Contact probe (1) comprising a first end (6) having a first contact tip (7) adapted to contact an electronic component under test, a second end (8) having a second contact tip (9) adapted to contact a probe card, and a central body (17) which extends between said first end (6) and said second end (8),
a cross-sectional area at said central body (17) being smaller than a cross-sectional area at said first end (6) and than a cross-sectional area at said second end (8),
wherein said central body (17) provides at least one portion with a rectilinear configuration (18), which develops along a longitudinal axis (x), and at least one portion with a curvilinear configuration (19), which moves away from said longitudinal axis (x),
and wherein an extension, measured along the longitudinal axis (x), of a first longitudinal section (D) comprising said second end (8) and said portion with a rectilinear configuration (18) and an extension, measured along the longitudinal axis (x), of a second longitudinal section (L) comprising said second end (8)
**characterised in that**
said central body (17) is sized so that a reciprocal ratio (D/L) between the extension of the first longitudinal section (D) and the extension of the second longitudinal section (L) is between 0.4 and 0.65.

2. Contact probe (1) according to claim 1, wherein at least one cross section of said central body (17) has a thickness (S) and a width (T) which are orthogonal to each other, the width (T) being greater than the thickness (S).

3. Contact probe (1) according to claim 2, wherein, when the width (T) of said central body (17) is equal to the thickness (S) of said central body (17) multiplied by a shape factor (k), the factor (k) is between 1.2 and 1.95.

4. Contact probe (1) according to one of claims 2 or 3, wherein an extension, measured along the longitudinal axis (x), of a third longitudinal section (H) of said central body (17) comprised between said first end (6) and said second end (8) is between 100 times and 150 times the thickness (S).

5. Contact probe (1) according to any one of the previous claims, wherein said first end (6) comprises a first portion with a larger section (10) and a second portion with a smaller section (11), said first contact tip (7) being at the end of said first portion with a smaller section (11).

6. Contact probe (1) according to claim 5, wherein a taper (18) is provided between said first portion with a larger section (10) and said first portion with a smaller section (11).

7. Contact probe (1) according to one of claims 5 or 6, wherein a step (12) is provided between said first portion with a larger section (10) and said first portion with a smaller section (11).

8. Contact probe (1) according to one of claims 5-7, wherein said portion with a smaller section (11) has a cross section with thickness and width which are equal to each other.

9. Contact probe (1) according to claim 8, wherein the thickness of said portion with a smaller section (11) is equal to the thickness of at least one cross section of said central body (17).

10. Contact probe (1) according to any one of the previous claims, wherein said second end (8) comprises a second portion with a larger section (14) and a second portion with a smaller section (15), said second contact tip (9) being in said second portion with a smaller section (15).

11. Contact probe (1) according to claim 10, comprising an abutment element (13) which is transverse to a longitudinal extension of said contact probe (1) laterally projecting with respect to said second portion with a larger section (14).

12. Contact probe (1) according to any one of the previous claims, wherein a first tapering portion is provided between said first end (6) and said central body (17).

13. Contact probe (1) according to any one of the previous claims, wherein a second tapering portion is provided between said second end (8) and said central body (17).

14. Contact probe (1) according to the previous claims, wherein the base of said second tapering portion defines a shoulder for resting on a lower guide plate (3).

15. Testing head (100) for a probe card comprising at least one contact probe (1) according to any of the previous claims 1 to 14, an upper guide plate (2) and a lower guide plate (3); said upper guide plate (2) and lower guide plate (3) respectively comprising a first guide hole (4) and a second guide hole (5) adapted to house the at least one contact probe (1).

## Patentansprüche

1. Kontaktsonde (1), umfassend ein erstes Ende (6) mit einer ersten Kontaktspitze (7), die dazu ausgelegt ist, ein zu prüfendes elektronisches Bauteil zu kontaktieren, ein zweites Ende (8) mit einer zweiten Kontaktspitze (9), die dazu ausgelegt ist, eine Sondenkarte zu kontaktieren, und einen Mittelkörper (17), der sich zwischen dem ersten Ende (6) und dem zweiten Ende (8) erstreckt,
wobei eine Querschnittsfläche am Mittelkörper (17) kleiner als eine Querschnittsfläche am ersten Ende (6) und kleiner als eine Querschnittsfläche am zweiten Ende (8) ist,
wobei der Mittelkörper (17) mindestens einen Abschnitt mit einer geradlinigen Konfiguration (18), der sich entlang einer Längsachse (x) entwickelt, und mindestens einen Abschnitt mit einer kurvilinearen Konfiguration (19), der sich von der Längsachse (x) wegbewegt, aufweist,
und wobei eine entlang der Längsachse (x) gemessene Ausdehnung eines ersten Längsabschnitts (D) das zweite Ende (8) und den Abschnitt mit der geradlinigen Konfiguration (18) umfasst und eine entlang der Längsachse (x) gemessene Ausdehnung eines zweiten Längsabschnitts (L) das zweite Ende (8) umfasst,
**dadurch gekennzeichnet, dass** der Mittelkörper (17) so bemessen ist, dass ein gegenseitiges Verhältnis (D/L) zwischen der Ausdehnung des ersten Längsabschnitts (D) und der Ausdehnung des zweiten Längsabschnitts (L) zwischen 0,4 und 0,65 liegt.

2. Kontaktsonde (1) nach Anspruch 1, wobei mindestens ein Querschnitt des Mittelkörpers (17) eine Dicke (S) und eine Breite (T) aufweist, die senkrecht zueinander sind, wobei die Breite (T) größer als die Dicke (S) ist.

3. Kontaktsonde (1) nach Anspruch 2, wobei, wenn die Breite (T) des Mittelkörpers (17) gleich der Dicke (S) des Mittelkörpers (17) multipliziert mit einem Formfaktor (k) ist, der Faktor (k) zwischen 1,2 und 1,95 liegt.

4. Kontaktsonde (1) nach einem der Ansprüche 2 oder 3, wobei eine entlang der Längsachse (x) gemessene Ausdehnung eines dritten Längsabschnitts (H) des Mittelkörpers (17), der zwischen dem ersten Ende (6) und dem zweiten Ende (8) liegt, zwischen dem 100-fachen und dem 150-fachen der Dicke (S) beträgt.

5. Kontaktsonde (1) nach einem der vorhergehenden Ansprüche, wobei das erste Ende (6) einen ersten Abschnitt mit einem größeren Schnitt (10) und einen zweiten Abschnitt mit einem kleineren Schnitt (11) umfasst, wobei die erste Kontaktspitze (7) am Ende des ersten Abschnitts mit einem kleineren Schnitt (11) liegt.

6. Kontaktsonde (1) nach Anspruch 5, wobei eine Verjüngung (18) zwischen dem ersten Abschnitt mit einem größeren Schnitt (10) und dem ersten Abschnitt mit einem kleineren Schnitt (11) vorgesehen ist.

7. Kontaktsonde (1) nach einem der Ansprüche 5 oder 6, wobei eine Stufe (12) zwischen dem ersten Abschnitt mit einem größeren Schnitt (10) und dem ersten Abschnitt mit einem kleineren Schnitt (11) vorgesehen ist.

8. Kontaktsonde (1) nach einem der Ansprüche 5 bis 7, wobei der Abschnitt mit einem kleineren Schnitt (11) einen Querschnitt mit gleicher Dicke und Breite aufweist.

9. Kontaktsonde (1) nach Anspruch 8, wobei die Dicke des Abschnitts mit einem kleineren Schnitt (11) gleich der Dicke mindestens eines Querschnitts des Mittelkörpers (17) ist.

10. Kontaktsonde (1) nach einem der vorhergehenden Ansprüche, wobei das zweite Ende (8) einen zweiten Abschnitt mit einem größeren Schnitt (14) und einen zweiten Abschnitt mit einem kleineren Schnitt (15) umfasst, wobei die zweite Kontaktspitze (9) im zweiten Abschnitt mit einem kleineren Schnitt (15) liegt.

11. Kontaktsonde (1) nach Anspruch 10, umfassend ein Anschlagelement (13), das quer zur Längserstreckung der Kontaktsonde (1) verläuft und seitlich bezüglich des zweiten Abschnitts mit einem größeren Schnitt (14) vorsteht.

12. Kontaktsonde (1) nach einem der vorhergehenden Ansprüche, wobei ein erster Verjüngungsabschnitt zwischen dem ersten Ende (6) und dem Mittelkörper (17) vorgesehen ist.

13. Kontaktsonde (1) nach einem der vorhergehenden Ansprüche, wobei ein zweiter Verjüngungsabschnitt zwischen dem zweiten Ende (8) und dem Mittelkörper (17) vorgesehen ist.

14. Kontaktsonde (1) nach den vorhergehenden Ansprüchen, wobei die Basis des zweiten Verjüngungsabschnitts eine Schulter zum Aufliegen auf einer unteren Führungsplatte (3) definiert.

15. Prüfkopf (100) für eine Sondenkarte, umfassend mindestens eine Kontaktsonde (1) nach einem der vorhergehenden Ansprüche 1 bis 14, eine obere Führungsplatte (2) und eine untere Führungsplatte (3); wobei die obere Führungsplatte (2) und die untere Führungsplatte (3) jeweils ein erstes Führungsloch (4) und ein zweites Führungsloch (5) umfassen, die dazu ausgelegt sind, die mindestens eine Kontaktsonde (1) aufzunehmen.

## Revendications

1. Sonde de contact (1) comprenant une première extrémité (6) présentant une première pointe de contact (7) apte à venir en contact avec un composant électronique en cours de test, une seconde extrémité (8) présentant une seconde pointe de contact (9) apte à venir en contact avec une carte à pointes, et un corps central (17) qui s'étend entre ladite première extrémité (6) et ladite seconde extrémité (8),
une aire de section transversale au niveau dudit corps central (17) étant inférieure à une aire de section transversale au niveau de ladite première extrémité (6) et à une aire de section transversale au niveau de ladite seconde extrémité (8),
dans laquelle ledit corps central (17) présente au moins une partie ayant une configuration rectiligne (18), qui s'étend le long d'un axe longitudinal (x), et au moins une partie ayant une configuration curviligne (19), qui s'écarte dudit axe longitudinal (x),
et dans laquelle une extension, mesurée le long de l'axe longitudinal (x), d'un premier tronçon longitudinal (D) comprenant ladite seconde extrémité (8) et ladite partie ayant une configuration rectiligne (18), et une extension, mesurée le long de l'axe longitudinal (x), d'un deuxième tronçon longitudinal (L) comprenant ladite seconde extrémité (8), sont définies,
**caractérisée en ce que** ledit corps central (17) est dimensionné de sorte qu'un rapport réciproque (D/L) entre l'extension du premier tronçon longitudinal (D) et l'extension du deuxième tronçon longitudinal (L) soit compris entre 0,4 et 0,65.

2. Sonde de contact (1) selon la revendication 1, dans laquelle au moins une section transversale dudit corps central (17) présente une épaisseur (S) et une largeur (T) qui sont orthogonales l'une à l'autre, la largeur (T) étant supérieure à l'épaisseur (S).

3. Sonde de contact (1) selon la revendication 2, dans laquelle, lorsque la largeur (T) dudit corps central (17) est égale à l'épaisseur (S) dudit corps central (17) multipliée par un facteur de forme (k), le facteur (k) est compris entre 1,2 et 1,95.

4. Sonde de contact (1) selon l'une des revendications 2 ou 3, dans laquelle une extension, mesurée le long de l'axe longitudinal (x), d'un troisième tronçon longitudinal (H) dudit corps central (17) compris entre ladite première extrémité (6) et ladite seconde extrémité (8) est comprise entre 100 fois et 150 fois l'épaisseur (S).

5. Sonde de contact (1) selon l'une quelconque des revendications précédentes, dans laquelle ladite première extrémité (6) comprend une première partie de plus grande section (10) et une seconde partie de plus petite section (11), ladite première pointe de contact (7) étant située à l'extrémité de ladite première partie de plus petite section (11).

6. Sonde de contact (1) selon la revendication 5, dans laquelle une partie effilée (18) est prévue entre ladite première partie de plus grande section (10) et ladite première partie de plus petite section (11).

7. Sonde de contact (1) selon l'une des revendications 5 ou 6, dans laquelle un épaulement (12) est prévu entre ladite première partie de plus grande section (10) et ladite première partie de plus petite section (11).

8. Sonde de contact (1) selon l'une des revendications 5 à 7, dans laquelle ladite partie de plus petite section (11) présente une section transversale dont l'épaisseur et la largeur sont égales entre elles.

9. Sonde de contact (1) selon la revendication 8, dans laquelle l'épaisseur de ladite partie de plus petite section (11) est égale à l'épaisseur d'au moins une section transversale dudit corps central (17).

10. Sonde de contact (1) selon l'une quelconque des revendications précédentes, dans laquelle ladite seconde extrémité (8) comprend une seconde partie de plus grande section (14) et une seconde partie de plus petite section (15), ladite seconde pointe de contact (9) étant située dans ladite seconde partie de plus petite section (15).

11. Sonde de contact (1) selon la revendication 10, comprenant un élément de butée (13) qui est transversal par rapport à une extension longitudinale de ladite sonde de contact (1) et faisant saillie latéralement par rapport à ladite seconde partie de plus grande section (14).

12. Sonde de contact (1) selon l'une quelconque des revendications précédentes, dans laquelle une première partie effilée est prévue entre ladite première extrémité (6) et ledit corps central (17).

13. Sonde de contact (1) selon l'une quelconque des revendications précédentes, dans laquelle une seconde partie effilée est prévue entre ladite seconde extrémité (8) et ledit corps central (17).

14. Sonde de contact (1) selon les revendications précédentes, dans laquelle la base de ladite seconde partie effilée définit un épaulement destiné à reposer sur une plaque de guidage inférieure (3).

15. Tête de test (100) pour une carte à pointes, comprenant au moins une sonde de contact (1) selon l'une quelconque des revendications 1 à 14 précédentes, une plaque de guidage supérieure (2) et une plaque de guidage inférieure (3) ; ladite plaque de guidage supérieure (2) et ladite plaque de guidage inférieure (3) comprenant respectivement un premier trou de guidage (4) et un second trou de guidage (5) aptes à loger ladite au moins une sonde de contact (1).
